# EUROPÄISCHE PATENTANMELDUNG

(11) **EP 2 361 001 A1**
(43) Veröffentlichungstag der Anmeldung: **24.08.2011**
(21) Anmeldenummer: 11150130.0
(22) Anmeldetag: 04.01.2011
(51) Int. Cl.: H05K 3/34

(54) **Lötmaske für Wellenlötverfahren und Verfahren zum Selektivlöten einzelner Bauteile einer Leiterplatte in einem Wellenlöt-Automaten**

(30) Priorität: 19.02.2010 DE 102010002150
(71) Anmelder: Endress + Hauser GmbH + Co. KG, 79689 Maulburg (DE)
(72) Erfinder: Birgel, Dietmar, 79650 Schopfheim (DE); Feucht, Michael, 79686 Hasel (DE); Glatz, Franz, 79106 Freiburg (DE); Oschwald, Joachim, 79669 Zell (DE)
(74) Vertreter: Andres, Angelika Maria

(57) **Zusammenfassung**

Die Erfindung betrifft eine Lötmaske für Wellenlötverfahren und Verfahren zum Selektivlöten einzelner Bauteile einer Leiterplatte. Die Lötmaske (34) dient dabei zur Aufnahme und Halterung einer Leiterplatte (10), deren Unterseite (14) in einem Wellenlöt-Automaten gelötet werden soll.

Die Lötmaske (34) weist dazu mindestens eine partielle Wärmeübertragungszone (40) auf, mittels der die Wärme der Lotwelle (42) indirekt an eine auf einer Oberseite (12) der Leiterplatte (10) befindliche Lotstelle (20, 26) mit Lotdepot (28) und/oder ein dort zu lötendes Bauteil (32) geleitet wird.

## Beschreibung

Wellenlötverfahren finden als Selektivlötverfahren vor allem Anwendung beim Löten von gemischt und beidseitig bestückten Leiterplatten, die also sowohl mit SMD- als auch mit THT-Bauteilen bestückt werden. Häufig werden die SMD-Bauteile dabei in einem Reflow-Lötofen gelötet. Verschiedentlich werden aber auch SMD-Bauteile auf einer Unterseite der Leiterplatte, bezogen auf die Lage beim Wellenlöten, in einem Wellen-Lötautomaten gelötet.

Die bedrahteten THT-Bauteile, unter denen im Folgenden alle Bauteile und Bauelemente verstanden werden, die mittels Anschlussdrähten bzw. Anschlusspins kontaktiert und befestigt werden, werden üblicherweise mit einem Selektivlötverfahren im Anschluss an die Lötung der SMD-Bauteile im Reflow-Lötofen gelötet. Dies gilt besonders für preisgünstige THT-Bauteile, die die hohen Temperaturspitzen im Reflow-Lötofen nicht überstehen.

Beim Wellenlöten von bereits in einem Reflow-Lötofen gelöteten, gemischt bestückten Leiterplatten werden üblicherweise Lötmasken zur Aufnahme und Fixierung der zu lötenden Module, Leiterplatten und/oder Bauteile verwendet. Mit diesen Lötmasken wird sichergestellt, dass ein definiertes Lötniveau eingehalten wird und es zu keinen Überflutungen oder Fehl-Lötungen kommt.

Bekannte Lötmasken werden daher einerseits zum Abdecken bestimmter Bereiche der zu lötenden Leiterplatte oder zu schützender, bereits gelöteter Bauteile verwendet. Auf diese Weise werden beispielsweise bereits gelötete unterseitige SMD-Bauteile auf einer doppelseitig Reflow-gelöteten Leiterplatte von der Lötmaske gegen Flussmittel, Temperatur der Lotwelle und Lot geschützt.

Andererseits erlauben Lötfenster in einer Lötmaske, dass Anschlusspins bzw. Anschlussdrähte der THT-Bauteile, die sich in den Lötfenstern befinden, von der Lotwelle benetzt und gelötet werden. Zum Festhalten von Bauteilen können Befestigungselemente, zum Beispiel sogenannte Niederhalter mit oder ohne Abstandshalter, direkt auf der Lötmaske oder auf darauf angebrachten Stegen befestigt sein. So können auch hohe bedrahtete Bauteile in der Position fixiert werden, die sonst mittels Tape oder Heißkleber befestigt werden müssten.

Infolge der Bauteildichte auf heutigen Leiterplatten ist der zum Löten von Anschlusspins von THT-Bauteilen zur Verfügung stehende Platz begrenzt, so dass in vielen Fällen die Lotwelle einer Wellenlötanlage die zu lötenden Anschlusspins nicht erreicht. Um dennoch Anschlusspins von THT-Bauteilen möglichst in einem Massenlötverfahren löten zu können und insbesondere hinreichend Lot an den Anschlußpads für die THT-Bauteile zu haben, besteht zwar die Möglichkeit mit Lotdepots zu arbeiten, das jeweilige Lotdepot muss dann jedoch in einem zusätzlichen Arbeitsschritt aufgeschmolzen werden, um die gewünschten Anschlusspins von THT-Bauteilen zu löten.

Der Erfindung liegt daher die Aufgabe zugrunde, die oben beschriebenen Nachteile zu vermeiden und ein neues Verfahren anzugeben, mit dem das Löten von Anschlusspins von THT-Bauteilen mittels Lotdepot in einem Massenlötverfahren wie beispielsweise Wellenlöten realisiert werden kann.

Diese Aufgabe wird gelöst durch eine Lötmaske für Wellenlötverfahren und zur Aufnahme und Halterung wenigstens einer auf einer Unterseite zu lötenden Leiterplatte, welche
- mindestens eine Abdeckung zum Schutz von bereits auf die Unterseite der Leiterplatte gelöteten SMD-Bauteilen und
- mindestens eine partielle Wärmeübertragungszone aufweist, um die Wärme der Lotwelle indirekt an eine auf einer Oberseite der Leiterplatte befindlichen, zu lötenden Lotstelle der Leiterplatte mit Lotdepot und/oder ein dort zu lötendes Bauteil zu leiten.

Eine besondere Ausführungsform der erfindungsgemäßen Lötmaske ist teilweise aus einem wärmeleitfähigem Material hergestellt.

Bei einer besonderen Ausgestaltung der Lötmaske nach der Erfindung wird die Wärmeübertragungszone aus einer metallischen Beschichtung der Lötmaske gebildet.

Bei einer anderen, besonderen Ausgestaltung der Lötmaske nach der Erfindung wird die Wärmeübertragungszone aus einer partiellen, metallischen Einlagerung in der Lötmaske gebildet.

Bei einer weiteren Ausführungsform der erfindungsgemäßen Lötmaske ist wenigstens eine Wärmeübertragungszone im Bereich eines Lötfensters angeordnet.

Eine andere Ausführungsform der erfindungsgemäßen Lötmaske weist wenigstens eine Niederhalte-Vorrichtung zum Halten von zu lötenden Bauteilen auf.

Die oben genannte, dieser Erfindung zugrunde liegende Aufgabe wird auch gelöst durch ein erfindungsgemäßes Verfahren zum Bestücken und Löten von Bauteilen auf einer Leiterplatte mit folgenden Verfahrensschritten:
a) aufbringen einer Lotpaste auf vorbestimmte Lötpads auf einer ersten Seite der Leiterplatte;
b) bestücken der ersten Seite der Leiterplatte mit SMD-Bauteilen und Lotformteilen, wobei die SMD-Bauteile in die Lotpaste auf den dafür vorgesehenen Lötpads eingesetzt werden und wobei die Lotformteile einen höheren Schmelzpunkt haben als die Lotpaste und in unmittelbarer Nähe solcher Lotaugen platziert werden, die für eine Bestückung mit Anschlusspins bedrahteter Bauteile vorgesehen sind;
c) löten der ersten Seite der Leiterplatte und der darauf bestückten SMD-Bauteile in einem Reflow-Lötofen sowie Befestigen der Lotformteile auf der Leiterplatte;
d) wenden der Leiterplatte;
e) aufbringen von Lotpaste auf vorbestimmte Lötpads auf einer zweiten Seite der Leiterplatte;
f) bestücken der zweiten Seite der Leiterplatte mit SMD-Bauteilen indem sie in die Lotpaste auf den dafür vorgesehenen Lötpads eingesetzt werden;
g) löten der zweiten Seite der Leiterplatte und der darauf bestückten SMD-Bauteile in einem Reflow-Lötofen;
h) wenden der Leiterplatte;
i) bestücken der ersten Seite der Leiterplatte mit bedrahteten Bauteilen in Lötaugen, in deren unmittelbarer Nähe die Lotformteile angeordnet sind;
j) einlegen der zu lötenden Leiterplatte in eine Lötmaske mit partiellen Wärmeübertragungszonen in den Bereichen, wo auf der ersten Seite der Leiterplatte Lotformteile angeordnet sind; und
k) löten der Anschlusspins der bedrahteten Bauteile in einem Wellenlöt-Automaten, indem die Wärme der Lotwelle indirekt über die partiellen Wärmeübertragungszonen der Lötmaske zu den Lotformteilen auf der ersten Seite der Leiterplatte geleitet wird.

Die oben genannte, dieser Erfindung zugrunde liegende Aufgabe wird weiterhin gelöst durch ein erfindungsgemäßes Verfahren zum Bestücken und Löten von Bauteilen auf einer Leiterplatte mit folgenden Verfahrensschritten:
a) aufbringen einer Lotpaste auf vorbestimmte Lötpads auf einer ersten Seite der Leiterplatte;
b) bestücken der ersten Seite der Leiterplatte mit SMD-Bauteilen, indem sie in die Lotpaste auf den dafür vorgesehenen Lötpads eingesetzt werden;
c) löten der ersten Seite der Leiterplatte und der darauf bestückten SMD-Bauteile in einem Reflow-Lötofen;
d) wenden der Leiterplatte;
e) aufbringen von Lotpaste auf vorbestimmte Lötpads auf der zweiten Seite der Leiterplatte;
f) bestücken der zweiten Seite der Leiterplatte mit SMD-Bauteilen und Lotformteilen, wobei die SMD-Bauteile in die Lotpaste auf den dafür vorgesehenen Lötpads eingesetzt werden und wobei die Lotformteile einen höheren Schmelzpunkt haben als die Lotpaste und in unmittelbarer Nähe solcher Lotaugen platziert werden, die für eine Bestückung mit Anschlusspins bedrahteter Bauteile vorgesehen sind;
g) löten der zweiten Seite der Leiterplatte und der darauf bestückten SMD-Bauteile in einem Reflow-Lötofen sowie Befestigen der Lotformteile auf der Leiterplatte;
h) bestücken der zweiten Seite der Leiterplatte mit bedrahteten Bauteilen in Lötaugen, in deren unmittelbarer Nähe Lotformteile angeordnet sind;
i) einlegen der zu lötenden Leiterplatte in eine Lötmaske mit partiellen Wärmeübertragungszonen in den Bereichen, wo auf der zweiten Seite der Leiterplatte Lotformteile angeordnet sind; und
j) löten der Anschlusspins der bedrahteten Bauteile in einem Wellenlöt-Automaten, indem die Wärme der Lotwelle indirekt über die partiellen Wärmeübertragungszonen der Lötmaske zu den Lotformteilen auf der zweiten Seite der Leiterplatte geleitet wird.

In weiterer Ausgestaltung des erfindungsgemäßen Verfahrens ist vorgesehen, dass die Lotformteile in vorher auf die Leiterplatte aufgebrachte Kleber-Punkte eingesetzt werden.

Bei einer noch anderen Ausgestaltung des erfindungsgemäßen Verfahrens ist vorgesehen, dass die Lotformteile in die auf die Leiterplatte aufgebrachte Lotpaste eingesetzt werden.

Die oben genannte, dieser Erfindung zugrunde liegende Aufgabe wird außerdem gelöst durch ein erfindungsgemäßes Verfahren zum Selektivlöten einzelner Bauteile einer Leiterplatte in einem Wellenlöt-Automaten mit folgenden Verfahrensschritten:
a) einlegen der zu lötenden Leiterplatte in eine Lötmaske;
b) langsames Transportieren der Lötmaske mit der Leiterplatte über die Lotwelle,
   - zum Löten vorgegebener Anschlusspins bedrahteter Bauteile durch in der Lötmaske vorgesehener Lötfenster und
   - zur indirekten Übertragung der Wärme der Lotwelle auf wenigstens eine auf der Oberseite der Leiterplatte befindliche, zu lötende Lotstelle und/oder ein dort befindliches zu lötendes Bauteil,
c) wobei mittels mindestens einer partiellen Wärmeübertragungszone der Lötmaske eine indirekte Wärmeübertragung von der auf die Unterseite der Leiterplatte wirkende Lotwelle auf die Oberseite der Leiterplatte erzielt wird.

Der große Vorteil der Erfindung ist darin zu sehen, dass sie das indirekte Löten von Anschlusspins von THT-Bauteilen in einem Wellen-Lötautomaten ermöglicht, mit dem sonst bei hoher Bestückungsdichte der Leiterplatte keine Lötung durch die Lotwelle erreicht werden kann. Weiterhin erlaubt es die Erfindung, in ihrer Größe standardisierte Lotformteile zu verwenden, die eine automatische Bestückung der Lotformteile mit einem Bestückungsautomaten ermöglicht.
Die Erfindung wird nachstehend anhand der beigefügten Zeichnung genauer erläutert und erklärt. dabei zeigen:
- Fig. 1: eine skizzenhafte Teilschnittdarstellung einer Leiterplatte mit einem Ausführungsbeispiel einer erfindungsgemäßen Lötmaske;
- Fig. 2: eine skizzenhafte, vergrößerte Teilschnittdarstellung eines Lötauges der Leiterplatte nach Fig. 1 aus der durch einen Pfeil 46 in Fig. 1 veranschaulichten Blickrichtung;
- Fig. 3: ein erstes Ausführungsbeispiel eines erfindungsgemäßen Verfahrens zum Bestücken und Löten von Bauteilen auf einer Leiterplatte; und
- Fig. 4: ein zweites Ausführungsbeispiel eines erfindungsgemäßen Verfahrens.

Zur Vereinfachung sind in der Zeichnung gleiche Elemente, Bauteile, Module und Verfahrensschritte mit gleichen Bezugszeichen bezeichnet.

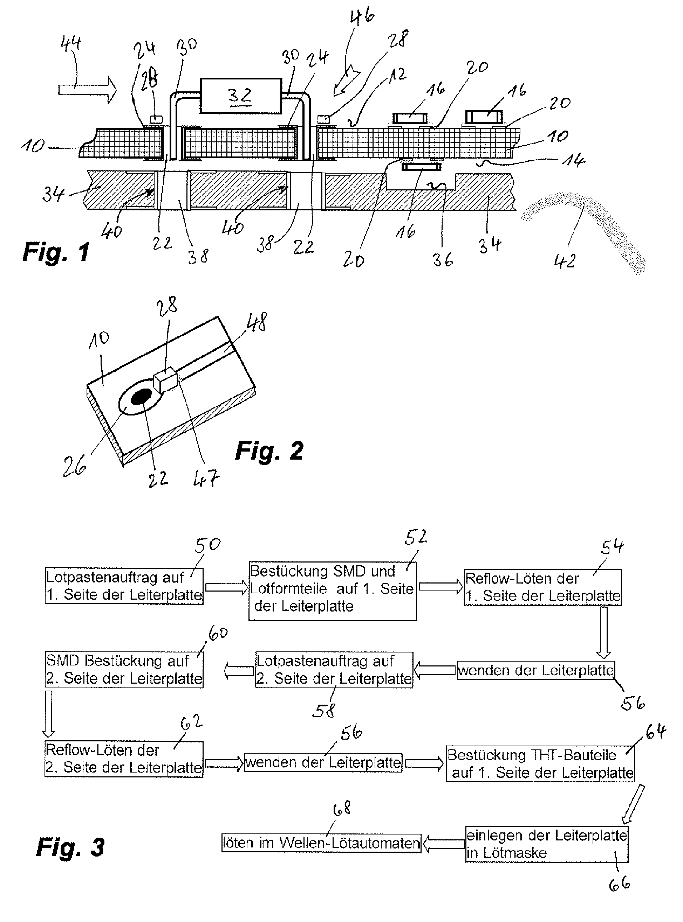

In Fig. 1 ist ein Teil einer beidseitig bestückten Leiterplatte 10 dargestellt, wobei sowohl ihre Oberseite 12 als auch ihre Unterseite 14 bereits nach dem erfindungsgemäßen Verfahren in einem hier nicht dargestellten Reflow-Lötofen gelötet wurde. Veranschaulicht wird dies hier am Beispiel zweier SMD-Bauteile 16 auf der Oberseite 12 der Leiterplatte 10 und einem anderen SMD-Bauteil 16 auf der Unterseite 14 der Leiterplatte 10, welche Bauteile auf die ihnen jeweils zugewiesenen Lötpads 20 gelötet wurden.

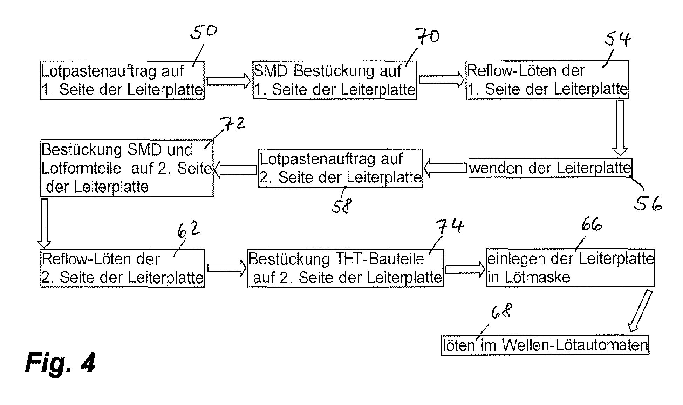

Beispielhaft zeigt Fig. 1 auch Anschlussbohrungen 22 für Anschlusspins 30 eines THT-Bauteils 32. Jede Anschlussbohrung 22 ist, wie üblich, mit einer Metallhülse 24 versehen, die üblicherweise mit wenigstens einem Lötauge 26 verbunden ist, mit dem der Anschlusspin 30 verlötet werden soll. Auf der Oberseite 12 der Leiterplatte 10 direkt neben den Lötaugen für die Anschlusspins 30 des THT-Bauteils 32, also auch direkt neben den Anschlussbohrungen 22 sind Lotformteile 28 angeordnet. Gemäß dem erfindungsgemäßen Verfahren, das nachfolgend und anhand der Fig. 3 und 4 noch genauer erläutert wird, sind die Lotformteile 28 zusammen mit den Bauteilen, beispielsweise den SMD-Bauteilen 16, der Oberseite 12 der Leiterplatte 10 im Reflow-Lötofen gelötet worden. Da die Lotformteile 28 erst nach den Lötdurchgängen der Leiterplatte 10 durch den Reflow-Lötofen zum Löten der Anschlusspins 30 des THT-Bauteils 32 geschmolzen werden sollen, haben die Lotformteile 28 eine höhere Schmelztemperatur als die Lotpaste, die zum Löten der SMD-Bauteile 16 im Reflow-Lötofen verwendet wird.

Fig. 1 veranschaulicht die Leiterplatte kurz vor dem indirekten Löten der Anschlusspins 30 des THT-Bauteils 32 in einem Wellen-Lötautomaten nach dem erfindungsgemäßen Verfahren. Demgemäß liegt die in Fig. 1 dargestellte Leiterplatte 10 auf einer erfindungsgemäßen Lötmaske 34 oder ist in sie eingesetzt. Zum Schutz des SMD-Bauteils 16, das bereits auf der Unterseite 14 der Leiterplatte 10 gelötet wurde, gegen die hier nur angedeutete Lotwelle 42 ist in der Lötmaske 34 auf der der Leiterplatte 10 zugewandten Seite eine Tasche 36 vorgesehen, die das zu schützende SMD-Bauteil 16 vollständig aufnimmt. Die Lötmaske sollte in direktem und dichten Kontakt mit der Unterseite 14 der Leiterplatte 10 sein, um einen möglichst verlustfreien Wärmeeintrag in die Leiterplatte 10 zu ermöglichen.

Die Lötmaske 34 ist bei dem in Fig. 1 dargestellten Ausführungsbeispiel im Bereich der Anschlussbohrungen 22 mit durchgängigen Fenstern 38 versehen, die ein Fluxen der Metallhülsen 24 der Anschlussbohrungen 22 und der dort hinein gesteckten Anschlusspins 30 des THT-Bauteils 32 ermöglicht. Zur besseren Wärmeeinleitung in die Leiterplatte 10 sind an den Fenstern Wärmeübertragungszonen 40 vorgesehen, die aus einer Metallisierung der Fenster 38 der Lötmaske 34 gebildet werden. Dies kann durch Metallhülsen für die Fenster 38 aber auch alternativ oder unterstützend durch Metalleinlagerungen in der Lötmaske 34 selbst realisiert werden. Die letztere Variante der Metalleinlagerungen in der Lötmaske 34 bieten sich besonders dann an, wenn keine Fenster 38 zum Fluxen der Metallhülsen 24 der Anschlussbohrungen 22 und der Anschlusspins 30 erforderlich sind, weil das Flussmittel auf andere Weise bereits auf die dafür vorgesehen Stellen der Leiterplatte 10 (hier: die Anschlussbohrungen 22) aufgetragen wurde. Denkbar sind auch Lotformteile 28, die mit Flussmittel beschichtet sind oder in ihrem Innern enthalten. Es ist klar, dass die Größe eventuell erforderlicher Fenster 38 in der Lötmaske 34 zu optimieren ist, da sie für eine Übertragung der Wärme der Lotwelle 42 durch die Lötmaske 34 und durch die Leiterplatte 10 auf deren Oberseite 12 zu den Lotformteilen 26 an sich nicht vorteilhaft sind. Fenster 38 sind daher möglichst zu vermeiden oder auf ein Minimum zu beschränken.

Die Transportrichtung der Leiterplatte 10 über die Lotwelle 42 des Wellenlötautomaten ist in Fig. 1 durch einen mit 44 bezeichneten Pfeil veranschaulicht.

Zur besseren Erläuterung der Positionierung des Lotformteils 28 ist in Fig. 2 das mit einer Leiterbahn 48 verbundene Lötauge 26 auf der Oberseite 12 der Leiterplatte 10 aus der durch den Pfeil 46 in Fig. 1 veranschaulichten Blickrichtung noch einmal vergrößert dargestellt. Vor dem Löten der Oberseite 12 der Leiterplatte 10 im Reflow-Lötofen ist das Lotformteil 28 in die dafür auf dem Lötauge 26 vorgesehene Lotpaste 47 einzusetzen. Das Lotformteil 28 ist möglichst nahe an der Anschlussbohrung 30 zu platzieren, ohne dass jedoch Gefahr besteht, dass die Lotpaste 47 beim Aufschmelzen im Reflow-Lötofen die Anschlussbohrung 30 beeinträchtigt. Es wurde bereits oben schon darauf hingewiesen, dass die Lotformteile 28 erst nach den Lötdurchgängen der Leiterplatte 10 durch den Reflow-Lötofen zum Löten der Anschlusspins 30 des THT-Bauteils 32 geschmolzen werden sollen. Die Lotformteile 28 haben daher eine höhere Schmelztemperatur als die Lotpaste, die zum Löten im Reflow-Lötofen verwendet wird.

Statt Löten der Lotformteile 28 auf die Oberseite 12 der Leiterplatte 10, wie oben beschrieben, ist es auch denkbar, die Lotformteile 28 durch Kleber im Bereich der Anschlussbohrung 30 zu befestigen, vorzugsweise mit SMD-Kleber. Der Kleber härtet im Reflow-Lötofen aus und hält die Lotformteile 28 sicher auf der Leiterplatte. Kleber kann wie die oben beschriebene Lotpaste auch, maschinell bestückt werden. Bei Verwendung eines Klebers zur Befestigung der Lotformteile 28 auf der Leiterplatte 10 ist jedoch zu beachten, dass der Kleber-Punkt für ein Lotformteil 28 auf der Seite des Lotformteils 28 vorgesehen wird, die von der Anschlussbohrung 22 abgewandt ist, um die thermische Anbindung des Lotformteils 28 bei dessen späterem Aufschmelzen nach dem erfindungsgemäßen Verfahren durch indirekten Wärmeeintrag durch die Leiterplatte 10 hindurch nicht zu beeinträchtigen.

Denkbar ist es, die Lötmaske nach Anspruch 1, nicht nur lokal begrenzt sonder großflächig aus wärmeleitfähigem und/oder wärmespeichernden Material herzustellen. damit wäre eine bessere Vorwärmung der Leiterplatte insgesamt zu erzielen.

Weiterhin kann es sinnvoll sein, die hier betrachtete Lötmaske, wie übliche Lötmasken auch mit Niederhalte-Vorrichtungen zum Halten von zu lötenden Bauteilen auszurüsten.

Nachfolgend werden beispielhaft zwei Ausführungsformen des Verfahrens zum Bestücken und Löten von Bauteilen auf einer Leiterplatte 10 anhand der Fig. 3 und 4 beschrieben und erklärt. Dabei ist im Sinne der chronologischen Reihenfolge der Verfahrensschritte von einer 1. Seite und von einer 2. Seite der Leiterplatte 10 die Rede. Im Vergleich zur Fig. 1 handelt es sich bei dem in Fig. 3 dargestellten Ausführungsbeispiel bei der 1. Seite der Leiterplatte 10 um die in Fig. 1 dargestellte Oberseite 12 der Leiterplatte 10 und bei der 2. Seite um die in Fig. 1 dargestellte Unterseite 14. Bei dem in Fig. 4 dargestellten Ausführungsbeispiel des erfindungsgemäßen Verfahrens ist die 1. Seite der Leiterplatte 10 die in Fig. 1 bezeichnete Unterseite 14 der Leiterplatte 10. Ansonsten entsprechen die bei der Erklärung der Verfahrensschritte angeführten SMD-Bauteile den in Fig. 1 mit "16" bezeichneten SMD-Bauteilen. Ähnliches gilt für die beim Verfahren beschriebenen THT-Bauteile, die im Wesentlichen dem in Fig. 1 dargestellten THT-Bauteil 32 entsprechen.

Zur Vereinfachung beginnt das in Fig. 3 dargestellte Ausführungsbeispiel des Verfahrens mit einem Lotpastenauftrag 50 auf der 1.Seite der Leiterplatte 10. Daraufhin folgt eine Bestückung 52 der 1. Seite der Leiterplatte mit SMD-Bauteilen 16 und Lotformteilen 28, wobei die SMD-Bauteile 16 in die Lotpaste auf den dafür vorgesehenen Lötpads 20 (siehe Fig. 1) eingesetzt werden und wobei die Lotformteile 28 ― mit einem höheren Schmelzpunkt als die Lotpaste - in die Lotpaste in unmittelbarer Nähe solcher Lotaugen 26 platziert werden, die für die spätere Bestückung mit den Anschlusspins 30 der THT-Bauteile 32 vorgesehen sind.

Die derart bestückte Leiterplatte 10 wird anschließend zum Reflowlöten 54 der 1. Seite der Leiterplatte 10 in den Reflow-Lötofen transportiert. Danach findet ein Wenden 56 der Leiterplatte 10 statt und ein Lotpastenauftrag 58 auf der 2.Seite der Leiterplatte 10. Bei der sich anschließenden Bestückung 60 der 2. Seite der Leiterplatte 10 werden nur SMD-Bauteile 16 in die Lotpaste auf den dafür vorgesehenen Lötpads 20 der 2. Seite der Leiterplatte 10 eingesetzt. Zum Reflowlöten 62 der 2. Seite der Leiterplatte 10 wird sie wieder in den Reflow-Lötofen gegeben. Danach wird die Leiterplatte wieder gewendet, was in Fig. 3 mit "56" bezeichnet ist, so dass von oben her die 1. Seite der Leiterplatte 10 mit den THT-Bauteilen 32 bestückt wird, die für das erfindungsgemäße, anschließende, indirekte Löten 68 im Wellenlötautomaten vorgesehen sind. Vor dem indirekten Löten 68 der Anschlusspins 30 der THT-Bauteile 32 im Wellenlötautomaten wird die Leiterplatte jedoch in eine erfindungsgemäße Lötmaske 34 (siehe dazu Fig. 1) eingelegt, was in Fig. 3 mit "66" bezeichnet und in Fig. 1 dargestellt ist. Wie bereits oben beschrieben, wird beim Löten 68 die Wärme der Lotwelle 42 (siehe Fig. 1) indirekt über die partiellen Wärmeübertragungszonen 40 der Lötmaske 34 zu den Lotformteilen 28 auf der 1. Seite der Leiterplatte 10 geleitet, so dass die aufschmelzenden Lotformteile die gewünschten Anschlusspins 30 der THT-Bauteile 32 verlöten.

Das in Fig. 4 dargestellte Ausführungsbeispiel des erfindungsgemäßen Verfahrens unterscheidet sich von dem in Fig. 3 dargestellten zunächst einmal darin, dass beim Verfahren nach Fig. 4 mit einer anderen Seite der Leiterplatte 10 begonnen wird, was bereits oben schon erklärt wurde, obwohl letztlich die THT-Bauteile von der gleichen Seite der Leiterplatte 10 bestückt werden. Im Gegensatz zum Verfahren nach Fig. 3 findet beim Verfahren nach Fig. 4 eine Bestückung 70 der 1. Seite der Leiterplatte 10 nur mit SMD-Bauteilen 16 statt. Die Lotformteile 28 werden erst nach dem Lotpastenauftrag 58 auf die 2. Seite der Leiterplatte 10 im Rahmen der Bestückung 72 der 2. Seite der Leiterplatte mit SMD-Bauteilen 16 und zusammen mit diesen bestückt. Nach dem Reflow-Löten 62 der 2. Seite der Leiterplatte 10 wird diese mit THT-Bauteilen 32 bestückt. Die übrigen Verfahrensschritte der in den Fig. 3 und 4 dargestellten Ausführungsbeispiele des erfindungsgemäßen Verfahrens stimmen im Wesentlichen überein, allerdings kann beim Verfahren nach Fig. 4 ein Wenden der Leiterplatte 10 nach dem Reflow-Löten der 2. Seite der Leiterplatte 10 entfallen.

Obwohl sich die Beschreibung der in den Fig. 3 und 4 dargestellten Ausführungsbeispiele des erfindungsgemäßen Verfahrens auf das Einsetzen und Befestigen der Lotformteile 28 auf der Leiterplatte 10 durch Lotpaste beschränkt hat, ist es für den Fachmann klar, dass, wie bereits oben beschrieben, die Lotformteile 28 auch auf die Leiterplatte 10 geklebt werden können.

Der indirekte Wärmeeintrag durch die Leiterplatte 10 nach dem beschriebenen erfindungsgemäßen Verfahren kann nicht nur dazu genutzt werden, Lotformteile 28 aufzuschmelzen sondern auch um die Lotkügelchen von hier nicht dargestellten oder weiter besprochenen Ball-Grid-Array-Bauteilen, die wie die oben beschriebenen Lotformteile in die Lotpaste eingesetzt werden, zu schmelzen und zu löten. Auch das setzt natürlich wieder voraus, dass die BGA-Lotkügelchen einen höheren Schmelzpunkt haben als die Lotpaste.

### Bezugszeichenliste

- 10: Leiterplatte
- 12: Oberseite der Leiterplatte
- 14: Unterseite der Leiterplatte
- 16: SMD-Bauteil
- 20: Lötpad
- 22: Anschlussbohrung
- 24: Metallhülse
- 26: Lötauge
- 28: Lotformteil
- 30: Anschlusspin
- 32: THT-Bauteil
- 34: Lötmaske
- 36: Tasche für SMD-Bauteil
- 38: Fenster
- 40: Wärmeübertragungszone
- 42: Lotwelle
- 44: Transportrichtung
- 46: Pfeil (Blickrichtung Fig. 2)
- 47: Lotpaste
- 48: Leiterbahn
- 50: Lotpastenauftrag auf 1.Seite der Leiterplatte
- 52: Bestückung der 1. Seite der Leiterplatte mit SMD-Bauteilen und Lotformteilen
- 54: Reflowlöten der 1. Seite der Leiterplatte
- 56: Wenden der Leiterplatte
- 58: Lotpastenauftrag auf 2.Seite der Leiterplatte
- 60: Bestückung der 2. Seite der Leiterplatte mit SMD-Bauteilen
- 62: Reflowlöten der 2. Seite der Leiterplatte
- 64: Bestückung der 1. Seite der Leiterplatte mit THT-Bauteilen
- 66: Einlegen der Leiterplatte in eine Lötmaske
- 68: Löten im Wellen-Lötautomaten
- 70: Bestückung der 1. Seite der Leiterplatte mit SMD-Bauteilen
- 72: Bestückung der 2. Seite der Leiterplatte mit SMD-Bauteilen und Lotformteilen
- 74: Bestückung der 2. Seite der Leiterplatte mit THT-Bauteilen

## Patentansprüche

1. Lötmaske für Wellenlötverfahren und zur Aufnahme und Halterung wenigstens einer auf einer Unterseite (14) zu lötenden Leiterplatte (10), welche
― mindestens eine Abdeckung (36) zum Schutz von bereits auf die Unterseite (14) der Leiterplatte (10) gelöteten SMD-Bauteilen (16) und
― mindestens eine partielle Wärmeübertragungszone (40) aufweist, um die Wärme der Lotwelle (42) indirekt an eine auf einer Oberseite (12) der Leiterplatte (10) befindlichen, zu lötende Lotstelle (20, 26) der Leiterplatte (10) mit Lotdepot (28) und/oder ein dort zu lötendes Bauteil (32) zu leiten.

2. Lötmaske (34) nach Anspruch 1, die teilweise aus einem wärmeleitfähigem Material hergestellt ist.

3. Lötmaske (34) nach Anspruch 2, bei der die Wärmeübertragungszone (40) aus einer metallischen Beschichtung der Lötmaske (34) gebildet wird.

4. Lötmaske (34) nach Anspruch 2, bei der die Wärmeübertragungszone (40) aus einer partiellen, metallischen Einlagerung in der Lötmaske (34) gebildet wird.

5. Lötmaske (34) nach einem der vorgehenden Ansprüche 1 bis 4, bei der wenigstens eine Wärmeübertragungszone (40) im Bereich eines Fensters (38) angeordnet ist.

6. Lötmaske (34) nach einem der vorgehenden Ansprüche 1 bis 5, die wenigstens eine Niederhalte-Vorrichtung zum Halten von zu lötenden Bauteilen aufweist.

7. Verfahren zum Bestücken und Löten von Bauteilen auf einer Leiterplatte (10) mit folgenden Verfahrensschritten:
a) Aufbringen (50) einer Lotpaste (47) auf vorbestimmte Lötpads (20) auf einer ersten Seite (12) der Leiterplatte (10);
b) Bestücken (52) der ersten Seite (12) der Leiterplatte (10) mit SMD-Bauteilen (16) und Lotformteilen (28), wobei die SMD-Bauteile (16) in die Lotpaste (47) auf den dafür vorgesehenen Lötpads (20) eingesetzt werden und wobei die Lotformteile (28) einen höheren Schmelzpunkt haben als die Lotpaste (47) und in unmittelbarer Nähe solcher Lotaugen (26) platziert werden, die für eine Bestückung mit Anschlusspins (30) bedrahteter Bauteile (32) vorgesehen sind;
c) Löten (54) der ersten Seite (12) der Leiterplatte (10) und der darauf bestückten SMD-Bauteile (16) in einem Reflow-Lötofen sowie Befestigen der Lotformteile (28) auf der Leiterplatte (28);
d) Wenden (56) der Leiterplatte (10);
e) Aufbringen (58) von Lotpaste (47) auf vorbestimmte Lötpads (20) auf einer zweiten Seite (14) der Leiterplatte (10);
f) Bestücken (60) der zweiten Seite (14) der Leiterplatte (10) mit SMD-Bauteilen (16), indem sie in die Lotpaste (47) auf den dafür vorgesehenen Lötpads (20) eingesetzt werden;
g) Löten (62) der zweiten Seite (14) der Leiterplatte (10) und der darauf bestückten SMD-Bauteile (16) in einem Reflow-Lötofen;
h) Wenden (56) der Leiterplatte (10);
i) Bestücken (64) der ersten Seite (12) der Leiterplatte (10) mit bedrahteten Bauteilen (32) in Lötaugen (26), in deren unmittelbarer Nähe die Lotformteile (28) angeordnet sind;
j) Einlegen (66) der zu lötenden Leiterplatte (10) in eine Lötmaske (34) mit partiellen Wärmeübertragungszonen (49) in den Bereichen, wo auf der ersten Seite (12) der Leiterplatte (10) Lotformteile (28) angeordnet sind; und
k) Löten (68) der Anschlusspins (30) der bedrahteten Bauteile (32) in einem Wellenlöt-Automaten, indem die Wärme der Lotwelle (42) indirekt über die partiellen Wärmeübertragungszonen (40) der Lötmaske (34) zu den Lotformteilen (28) auf der ersten Seite (12) der Leiterplatte (10) geleitet werden.

8. Verfahren zum Bestücken und Löten von Bauteilen auf einer Leiterplatte (10) mit folgenden Verfahrensschritten:
a) Aufbringen (50) einer Lotpaste (47) auf vorbestimmte Lötpads (20) auf einer ersten Seite (14) der Leiterplatte (10);
b) Bestücken (70) der ersten Seite (14) der Leiterplatte (10) mit SMD-Bauteilen (16), indem sie in die Lotpaste (47) auf den dafür vorgesehenen Lötpads (20) eingesetzt werden;
c) Löten (54) der ersten Seite (14) der Leiterplatte (10) und der darauf bestückten SMD-Bauteile (16) in einem Reflow-Lötofen;
d) Wenden (56) der Leiterplatte (10);
e) Aufbringen (58) von Lotpaste (47) auf vorbestimmte Lötpads (20) auf einer zweiten Seite (12) der Leiterplatte (10);
f) Bestücken (72) der zweiten Seite (12) der Leiterplatte (10) mit SMD-Bauteilen (16) und Lotformteilen (28), wobei die SMD-Bauteile (16) in die Lotpaste (47) auf den dafür vorgesehenen Lötpads (20) eingesetzt werden und wobei die Lotformteile (28) einen höheren Schmelzpunkt haben als die Lotpaste (47) und in unmittelbarer Nähe solcher Lotaugen (26) platziert werden, die für eine Bestückung mit Anschlusspins (30) bedrahteter Bauteile (32) vorgesehen sind;
g) Löten (62) der zweiten Seite (12) der Leiterplatte (10) und der darauf bestückten SMD-Bauteile (16) in einem Reflow-Lötofen sowie Befestigen der Lotformteile (28) auf der Leiterplatte (10);
h) Bestücken (74) der zweiten Seite (12) der Leiterplatte (10) mit bedrahteten Bauteilen (32) in Lötaugen (26), in deren in unmittelbarer Nähe Lotformteile (28) angeordnet sind;
i) Einlegen (66) der zu lötenden Leiterplatte (10) in eine Lötmaske (34) mit partiellen Wärmeübertragungszonen (40) in den Bereichen, wo auf der zweiten Seite (12) der Leiterplatte Lotformteile (28) angeordnet sind; und
j) Löten (68) der Anschlusspins (30) der bedrahteten Bauteile (32) in einem Wellenlöt-Automaten, indem die Wärme der Lotwelle (42) indirekt über die partiellen Wärmeübertragungszonen (40) der Lötmaske (34) zu den Lotformteilen (28) auf der zweiten Seite (12) der Leiterplatte (10) geleitet werden.

9. Verfahren nach einem der Ansprüche 7 oder 8, bei dem die Lotformteile (28) in vorher auf die Leiterplatte (10) aufgebrachte Kleber-Punkte eingesetzt werden.

10. Verfahren nach einem der Ansprüche 7 oder 8, bei dem die Lotformteile (28) in die auf die Leiterplatte (10) aufgebrachte Lotpaste (47) eingesetzt werden.

11. Verfahren zum Selektivlöten einzelner Bauteile (32) einer Leiterplatte (10) in einem Wellenlöt-Automaten mit folgenden Verfahrensschritten:
a) einlegen der zu lötenden Leiterplatte (10) in eine Lötmaske (34);
b) langsames Transportieren der Lötmaske (34) mit der Leiterplatte (10) über die Lotwelle (42),
- zum Löten vorgegebener Anschlusspins bedrahteter Bauteile durch in der Lötmaske (34) vorgesehener Fenster und
- zur indirekten Übertragung der Wärme der Lotwelle (42) auf wenigstens eine auf der Oberseite (12) der Leiterplatte (10) befindliche, zu lötende Lotstelle (26) und/oder ein dort befindliches zu lötendes Bauteil (28, 32),
c) wobei mittels mindestens einer partiellen Wärmeübertragungszone (40) der Lötmaske (34) eine indirekte Wärmeübertragung von der auf die Unterseite (14) der Leiterplatte (10) wirkende Lotwelle (42) auf die Oberseite (12) der Leiterplatte (10) erzielt wird.
